# EUROPÄISCHE PATENTANMELDUNG

(11) **EP 1 154 477 A1**
(43) Veröffentlichungstag der Anmeldung: **14.11.2001**
(21) Anmeldenummer: 00109977.9
(22) Anmeldetag: 11.05.2000
(51) Int. Cl.: H01L 23/485

(54) **Kontaktanschluss eines Halbleiterbauelements**

(71) Anmelder: Infineon Technologies AG, 81669 München (DE)
(72) Erfinder: Seidel, Uwe, 81737 München (DE); Schwerd, Markus, 83607 Holzkirchen (DE); Mitchell, Andrea Maria, 81667 München (DE); Koller, Klaus, 82110 Germering (DE); Helneder, Johann, 85652 Pliening (DE); Körner, Heinrich, 83052 Bruckmühl (DE); Schrenk, Michael Anton, 86911 Diessen (DE)
(74) Vertreter: Zimmermann & Partner

(57) **Zusammenfassung**

Der erfindungsgemäße Kontaktanschluß stellt auf dem Halbleiterbauelement einen elektrischen Kontakt zwischen der Verdrahtung und den Bonddrähten her. Der erfindungsgemäße Kontaktanschluß besitzt den Vorteil, daß ,selbst wenn es im Zusammenhang mit dem Bonden oder dem Aufsetzen von Meßnadeln zu einer Schädigung des zweiten elektrisch leitenden Elements kommt, dies nicht zu einer Schädigung des ersten elektrisch leitenden Elements führt. Durch die Tatsache, daß die vertikale Projektion der Bondfläche auf die erste Isolation, in die das erste elektrisch leitende Element eingebettet ist, neben dem ersten elektrisch leitenden Element angeordnet ist und somit das erste elektrisch leitende Element nicht schneidet, wird der Druck der Meßnadeln bzw. der bei dem Bondprozeß auftretende Druck von der ersten Isolation aufgenommen.

## Beschreibung

Die Erfindung betrifft die Kontaktanschlüsse eines Halbleiterbauelements, die in der Regel dazu genutzt werden, das Halbleiterbauelement mit seiner Umgebung elektrisch zu verbinden.

In hochintegrierten Speicher-, Logik- oder Hochfrequenz-Bausteinen werden elektrische Leiterbahnen zunehmend aus Kupfer hergestellt. Bei der Herstellung von Leiterbahnen aus Kupfer werden in der Regel in ein Oxid geätzte Gräben mit Kupfer, gefüllt und anschließend das überstehende Kupfer mittels eines CMP-Verfahrens (Chemisches Mechanisches Polieren) entfernt, so daß das Kupfer nur in den Gräben verbleibt. Kupfer besitzt gegenüber dem bisher verwendeten Aluminium den Vorteil, daß es eine größere Leitfähigkeit und eine geringere Neigung zur Elektromigration aufweist. Dementsprechend können durch die Verwendung von Kupfer feinere Leiterbahnen erzeugt werden, was positiv sich auf die erzielbare Integrationsdichte auswirkt.

Üblicherweise werden an den Bahnenden in der obersten Leiterbahnebene sogenannte Anschlußpads zur Kontaktierung bereitgestellt. Über diese Anschlußpads steht das integrierte Bauelement mit seiner Umgebung in Verbindung. Dazu wird in der Regel ein sogenannter Bonddraht auf ein Anschlußpad geführt und mit diesem dauerhaft verbunden. Verwendet man jedoch Kupfer als Metallisierungsmaterial, so ergeben sich daraus einige zusätzliche Schgwierigkeiten.

Durch die Temperaturbelastung und durch den Einfluß der Umgebungsatmosphäre beim Bondvorgang kommt es zu einer verstärkten Korrosion und Oxidation des ungeschützten Kupfers. Die Folge ist eine in der Regel schlechtere Bondqualität und eine nicht ausreichende Stärke der Verbindung zwischen Bonddraht und Kupferoberfläche. Da derzeit keine ausreichende Bondqualität auf Kupfer realisiert werden kann, werden über die Kupferpads durch weitere Arbeitsschritte Aluminium-Pads gelegt. Sie überdecken die darunterliegenden Kupfer-Pads vollständig und dienen als Kontaktierungsebene für die Bondung. Die elektrisch leitende Verbindung zwischen Aluminium- und Kupfer-Pads erfolgt üblicherweise durch direkten großflächigen Kontakt.

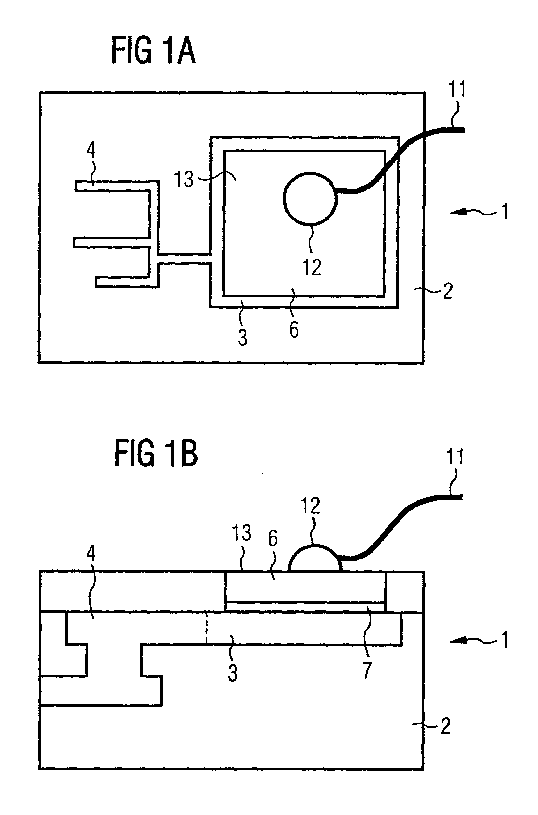

Die Figuren 1a und 1b zeigen einen Ausschnitt aus einem Halbleiterbauelement 1 mit einem ersten Kontaktanschluß nach dem Stand der Technik in Aufsicht und Querschnitt. Der Kontaktanschluß weist eine isolierenden Schicht 2, eine Kupferverdrahtung 4, ein erstes Anschlußpad 3 aus Kupfer und ein gut bondbares zweites Anschlußpad 6 aus Aluminium auf. Die Oberfläche des zweiten Anschlußpads 6 ist die Bondfläche 13. Der Bonddraht 11 ist auf der Bondfläche 13 aufgebracht, wobei sich beim Aufbringen der Bondfuß 12 gebildet hat.

Beim Drahtbonden wird ein lokaler Druck auf die Bondfläche 13 ausgeübt, so daß der Bonddraht 11 die Aluminiumschicht 6 durchdrücken kann und die zwischen der Aluminiumschicht 6 und der Kupferschicht 3 liegende Barriereschicht 7 aufgebrochen wird. Durch den direkten Kontakt zwischen Kupfer und Aluminium findet eine Interdiffusion zwischen der Aluminiumschicht und der Kupferschicht statt, so daß sich eine Cu-Al-Legierung an der Oberfläche bilden kann. Enthält diese Legierung zu viel Kupfer leidet die Bondbarkeit der Bondfläche 13.

Vor dem eigentlichen Bondvorgang werden die Bauelemente auf ihre elektrische Tauglichkeit geprüft. Zu diesem Zweck werden Meßnadeln auf die Anschlußpads aufgesetzt. Dabei wurde beobachtet, daß die aufsetzenden Meßnadeln die Aluminium-Pads beschädigen oder gar durchstoßen. Dabei kann es wiederum zu einer Zerstörung der Barriere zwischen Aluminium- und Kupferschicht kommen. Dies ist insbesondere dann der Fall, wenn für den elektrischen Test die Nadeln mehrmals aufgesetzt werden müssen. Bei der unter Punkt a) skizzierten Ausführung von übereinanderliegenden Pads aus Kupfer und Aluminium kann dadurch das darunterliegende Kupfer-Pad ungewollt geöffnet werden und somit eine Interdiffusion von Kupfer und Aluminium erfolgen. Dies hat eine Veränderung der Aluminium/Kupfer-Legierungsverhältnisses zur Folge und kann bei Anreicherung von Kupfer an der Oberfläche erneut die Gefahr der Oxidation mit sich bringen.

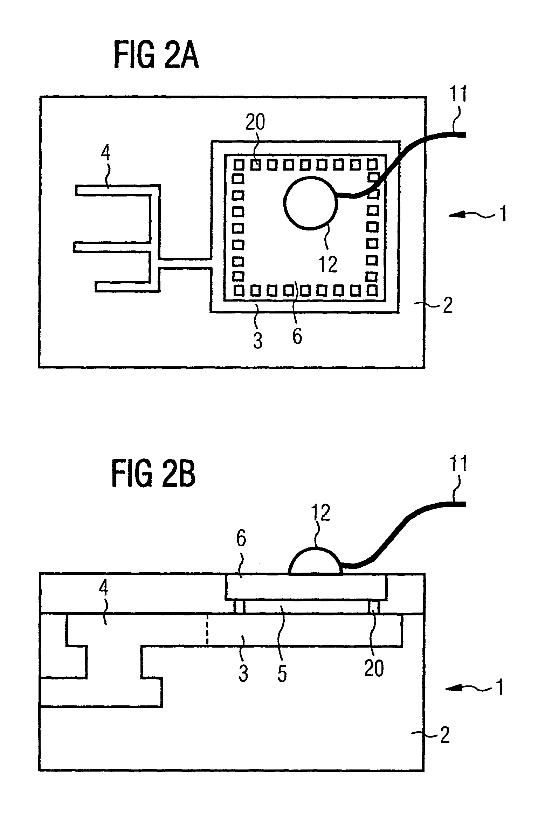

Ein bekanntes Verfahren zur Umgehung dieser Schwierigkeiten besteht darin, Kupfer-Pad 3 und Aluminium-Pad 6 durch eine Isolation 5 zu trennen wie in den Fig. 2a und 2b gezeigt. Die elektrische Verbindung zwischen beiden Pads wird dann durch Vias 20, die durch die isolierende Schicht hindurch gehen, erreicht. Dieser Aufbau unterdrückt Interdiffusion, wenn nur das Aluminium-Pad durchgedrückt wird.

Dieser Schichtaufbau hilft bei der Lösung jedoch nur teilweise. Zum einen kann der Prozeßverlauf erzwingen, daß die Schichtdicke der Isolation zwischen den beiden Pads dünn gehalten werden muß. In diesem Fall besteht weiterhin die Gefahr, beim Kontaktieren mittels einer Meßnadel oder beim Bondvorgang das Al-Pad und die Isolations durchzudrücken, so daß beide Pad-Materialien wieder in Kontakt miteinander geraten und interdiffundieren können. Zum anderen kann das Interdiffundieren im Via-Bereich dann einsetzen, wenn mit Meßnadel oder beim Bondvorgang auf einen der Vias aufgesetzt wird. Es muß daher dafür gesorgt werden, daß der Bereich der Via-Kontaktierung auf dem Al-Pad möglichst klein ist. Andererseits führen zu kleine Via-Durchmesser dazu, daß die Vias bei dem Aluminisierungsschritt zum Beispiel mittels Physical-Vapor-Deposition-(PVD) nur unzureichend gefüllt werden, was zu einer schlechten Kontaktierung führt. Desweiteren begrenzen diskrete Vias mit relativ kleinen Querschnittflächen den Stromtransport zwischen dem Kupfer-Pad 3 und dem Aluminium-Pad 6. So bleibt bei hochintegrierten Schaltungen nur ein kleines Realisierungsfenster zwischen den beiden Problemsituationen.

Der Erfindung liegt daher die Aufgabe zugrunde, einen Kontaktanschluß für ein Halbleiterbauelement zum Aufbringen von Bonddrähten derart weiterzubilden, daß die genannten Probleme vermindert bzw. ganz vermieden werden.

Eine erfindungsgemäße Lösung dieser Aufgabe ist in Patentanspruch 1 angegeben. Weitere vorteilhafte Ausführungsformen, Ausgestaltungen und Aspekte der vorliegenden Erfindung ergeben sich aus den abhängigen Patentansprüchen, der Beschreibung und den beiliegenden Zeichnungen.

Erfindungsgemäß wird ein Kontaktanschluß eines Halbleiterbauelements zum Aufbringen von Bonddrähten bereitgestellt, der dadurch gekennzeichnet ist, daß
a) der Kontaktanschluß ein erstes elektrisch leitendes Element aus einem ersten Material aufweist, das in einer ersten Isolation eingebettet ist und das mit einer Verdrahtung des Halbleiterbauelements elektrisch leitend verbunden oder Teil der Verdrahtung ist,
b) der Kontaktanschluß ein zweites elektrisch leitendes Element aus einem zweiten Material aufweist, das in einer zweiten Isolation eingebettet und/oder auf eine zweite Isolation aufgebracht ist und eine Bondfläche zum Aufbringen von Bonddrähten aufweist,
c) wobei das zweite Element durch mindestens eine elektrisch leitende Verbindung mit dem ersten Element verbunden ist und die vertikale Projektion der Bondfläche auf die erste Isolation neben dem ersten elektrisch leitenden Element angeordnet ist.

Der erfindungsgemäße Kontaktanschluß stellt auf dem Halbleiterbauelement einen elektrischen Kontakt zwischen der Verdrahtung und den Bonddrähten her. Der erfindungsgemäße Kontaktanschluß besitzt den Vorteil, daß, selbst wenn es im Zusammenhang mit dem Bonden oder dem Aufsetzen von Meßnadeln zu einer Schädigung des zweiten elektrisch leitenden Elements kommt, dies nicht zu einer Schädigung des ersten elektrisch leitenden Elements führt. Durch die Tatsache, daß die vertikale Projektion der Bondfläche auf die erste Isolation, in die das erste elektrisch leitende Element eingebettet ist, neben dem ersten elektrisch leitenden Element angeordnet ist und somit das erste elektrisch leitende Element nicht schneidet, wird der Druck der Meßnadeln bzw. der bei dem Bondprozeß auftretende Druck von der ersten Isolation aufgenommen. Eine Interdiffusion zwischen den Materialien der ersten und zweiten Elemente sowie eine Oxidation des Materials des ersten elektrisch leitenden Elements können somit zuverlässig vermieden werden. Weiterhin kann auf diese Weise die elektrisch leitende Verbindung zwischen dem ersten und dem zweiten elektrisch leitenden Element ausreichend groß gewählt werden, so die Herstellung dieser Verbindung einfacher zu realisieren ist.

Gemäß einer bevorzugten Ausführungsform ist das erste Material, aus dem das erste elektrisch leitende Element im wesentlichen besteht, Kupfer. Weiterhin ist es bevorzugt, wenn das zweite elektrisch leitende Element aus einem Material besteht, das gut bondbar ist. Gut bondbar heißt in diesem Zusammenhang, daß ein herkömmlicher Bondvorgang mit einem herkömmlichen Bonddraht und einem herkömmlichen Bondpad aus besagtem Material zu einer haltbaren Bondverbindung zwischen Bondpad und Bonddraht führt. Bevorzugtes Material ist Aluminium oder ein eine Mischung mit überwiegend Aluminium.

Gemäß einer bevorzugten Ausführungsform ist zwischen dem ersten elektrisch leitenden Element und dem zweiten elektrisch leitenden Element eine Barriere angeordnet. Dabei ist es insbesondere bevorzugt, wenn die Barriere eine Schicht aus Titan, Titannitrid Tantal, Tantalnitrid, Wolfram oder Wolframnitrid aufweist.

Weiterhin ist es bevorzugt, wenn die Breite des ersten elektrisch leitenden Elements gleich der Breite einer Leiterbahn in der obersten Verdrahtungsebene ist. Das erste elektrisch leitende Element entspricht somit im wesentlichen einer stumpf endenden Leiterbahn in der obersten Verdrahtungsebene. Auf die nach dem Stand der Technik übliche Verwendung großflächiger Leiterbahnpads in der obersten Verdrahtunsebene wird gemäß dieser bevorzugten Ausführungsform verzichtet.

Weiterhin ist es bevorzugt, wenn die erste Isolation ein Polymer oder ein Siliziumdioxid, das eine relative Dielektrizitätskonstante von kleiner als 3 aufweist, ist. Da bei dem erfindungsgemäßen Kontaktanschluß unterhalb der Bondfläche im wesentlichen nur Isolation angeordnet ist, kann der Druck, der durch Meßnadeln oder durch das Boden ausgeübt wird, besser aufgenommen werden als dies der Fall ist, wenn so unterschiedliche Materialien wie Metallpads und Isolation unter der Bondfläche angeordnet sind. Dementsprechend ist es vorteilhaft, den erfindungsgemäßen Kontaktanschluß insbesondere dann einzusetzen, wenn diese neuen Materialien als Intermetalldielektrum (IMD) eingesetzt werden. Die im Vergleich zu den herkömmlichen IMD-Materialien geringere mechanische Stabilität der neuen IMD-Materialien kann durch das verbesserte mechanische Design des erfindungsgemäßen Kontaktanschlusses ausgeglichen werden.

Im folgenden werden Kontaktanschlüsse nach Stand der Technik und ein erfindungsgemäßer Kontaktanschluß in den Figuren 1 bis 3 gezeigt. Es zeigen:
- Fig.1a - 1b: einen Kontaktanschluß nach Stand der Technik,
- Fig.2a - 2b: einen weiteren Kontaktanschluß nach Stand der Technik,
- Fig.3a - 3b: einen erfindungsgemäßer Kontaktanschluß.

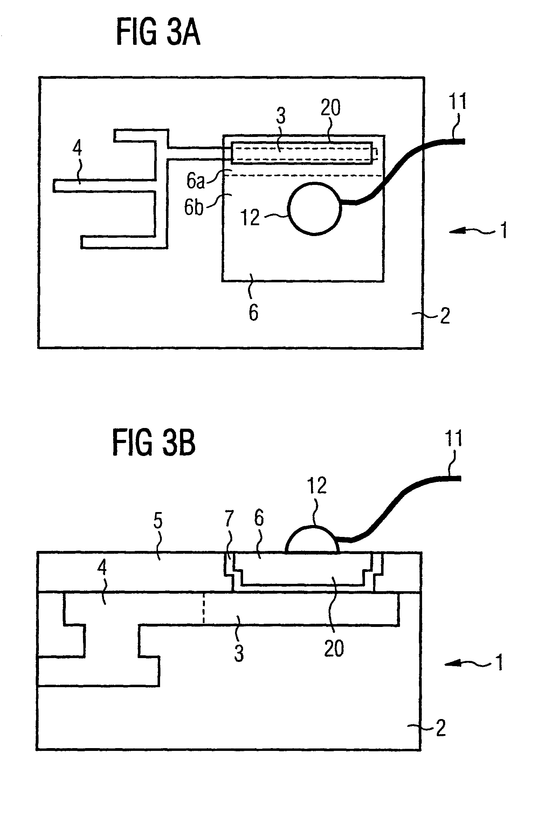

Fig. 3a und 3b zeigen eine Ausführung eines erfindungsgemäßen Kontaktanschlußes mit ersten und zweiten elektrisch leitenden Elementen 3 und 6. In dieser Ausführung ist das erste elektrisch leitende Element 3 Teil der obersten Verdrahtungsebene, die vollständig aus Kupfer aufgebaut ist. Zur Herstellung der obersten Verdrahtungsebene wurden die Konturen der Leiterbahnen in eine erste Isolation 2 geätzt und nachfolgend das Kupfer in die so erzeugten Gräben abgeschieden. Durch einen anschließenden CMP-Schritt wurde das Kupfer außerhalb der Gräben vollständig entfernt, so daß nur noch die strukturierten Leiterbahnen 4 sowie das erste Element 3 eingebettet in die erste Isolation 2 auf dem Halbleiterbauelement verbleiben. Im vorliegenden Beispiel ist die Isolation 2 aus einem sogenannten "low-k" Material gefertigt, um die parasitären Kapazitäten der Verdrahtung zu senken. Als ein derartiges Material kann beispielsweise das Polymer "SiLK" verwendet werden, das von der DOW Chemical Company hergestellt wird. Es kann aber auch herkömmliches Siliziumoxid verwendet werden.

Über der ersten Isolation 2 wurde nachfolgend eine zweite Isolation 5 erzeugt, die auch als Passivierung des Halbleiterbauelements genutzt wird. Als Material für diese zweite Isolation 5 kann beispielsweise Siliziumnitrid verwendet werden. Zur Erzeugung des zweiten elektrisch leitenden Elements 6 sowie der leitenden Verbindung 20 wurden eine Vertiefung sowie ein Via in der zweiten Isolation erzeugt, in die nachfolgend das Barrierematerial, beispielsweise Titannitrid, und das Aluminium abgeschieden wurde. Das Barrierematerial kann dabei beispielsweise durch eine PVD-Verfahren (Physical Vapor Deposition) abgeschieden werden. Wiederum wurde das überschüssige Aluminium durch einen CMP-Schritt von der Oberfläche der zweiten Isolation entfernt.

Bedingt durch den Herstellungsprozeß ist im vorliegenden Beispiel das Aluminium-Pad 6 in die zweite Isolation 5 eingebettet. Alternativ dazu kann das Aluminium-Pad jedoch auch auf der zweiten Isolation 5 angeordnet sein. In diesem Fall wird nur der Via 20 in der zweiten Isolation 5 erzeugt. Über den Via 20 sind das erste und das zweite leitende Element 3, 6 elektrisch leitend miteinander verbunden.

Das Aluminium-Pad 6 läßt sich in eine Fläche 6a, in der Via 20 an das Aluminium-Pad anschließt, und eine Fläche 6b, welche die Bondfläche 13 darstellt, aufteilen. Beide Flächen sind in Fig. 3a durch eine gestrichelte Linie getrennt dargestellt. Die Fläche 6a liegt ferner am Rande des Aluminium-Pads 6, so daß die übrige Fläche vollständig für die Bondung zur Verfügung steht. Auf diese Weise kann man die Fläche des Aluminium-Pads klein halten, was für eine hochintegrierte Schaltung von Vorteil ist. Der Via-Querschnitt ist hinreichend groß gewählt, damit bei der Füllung der Via-Öffnung mit einem leitenden Material, hier mit Aluminium, keine Hohlräume entstehen, die eine fehlerhafte Verbindung zwischen beiden elektrisch leitenden Elementen 3 und 6 hervorrufen können. Weiterhin gewährleistet der Via-Querschnitt einen hinreichend großen Stromfluß durch den Via. Da in diesem Aufbau nur ein Via vorhanden ist, kann die Fläche 6a klein gegenüber der Bondfläche 6b gehalten werden.

Erfindungsgemäß ist die Bondfläche 6b so ausgebildet, daß die vertikale Projektion der Bondfläche 6b auf die erste Isolation 2 neben dem ersten elektrisch leitenden Element 3 angeordnet ist. Dies hat zur Folge, daß sich die vertikale Projektion der Bondfläche 6b nicht mit dem ersten elektrisch leitenden Elements 3 schneidet. Dementsprechend wird der Druck der Meßnadeln bzw. der bei dem Bondprozeß auftretende Druck von der ersten Isolation aufgenommen. Eine Interdiffusion zwischen den Materialien der ersten und zweiten Elemente sowie eine Oxidation des Materials des ersten elektrisch leitenden Elements können somit zuverlässig vermieden werden.

## Patentansprüche

1. Kontaktanschluß für ein Halbleiterbauelement zum Aufbringen von Bonddrähten,
**dadurch gekennzeichnet, daß**
d) der Kontaktanschluß ein erstes elektrisch leitendes Element (3) aus einem ersten Material aufweist, das in einer ersten Isolation (2) eingebettet ist und das mit einer Verdrahtung (4) des Halbleiterbauelements elektrisch leitend verbunden oder Teil der Verdrahtung (4) ist,
e) der Kontaktanschluß ein zweites elektrisch leitendes Element (6) aus einem zweiten Material aufweist, das in einer zweiten Isolation (5) eingebettet und/oder auf eine zweite Isolation (5) aufgebracht ist und eine Bondfläche (6b) zum Aufbringen von Bonddrähten aufweist,
f) wobei das zweite Element (6) durch mindestens eine elektrisch leitende Verbindung (20) mit dem ersten Element (3) verbunden ist und die vertikale Projektion der Bondfläche (6b) auf die erste Isolation (2) neben dem ersten elektrisch leitende Element (3) angeordnet ist.

2. Kontaktanschluß nach Anspruch 1,
**dadurch gekennzeichnet, daß**
das erste Material Kupfer ist.

3. Kontaktanschluß nach Anspruch 1 oder 2,
**dadurch gekennzeichnet, daß**
das zweite Material Aluminium ist.

4. Kontaktanschluß nach einem der vorhergehenden Ansprüche,
**dadurch gekennzeichnet, daß**
zwischen dem ersten elektrisch leitenden Element (3) und dem zweiten elektrisch leitenden Element (6) eine Barriere (7) angeordnet ist.

5. Kontaktanschluß nach Anspruch 4,
**dadurch gekennzeichnet, daß**
die Barriere (7) eine Schicht aus Titan, Titannitrid Tantal, Tantalnitrid, Wolfram oder Wolframnitrid aufweist.

6. Kontaktanschluß nach einem der vorhergehenden Ansprüche,
**dadurch gekennzeichnet, daß**
die Breite des ersten elektrisch leitenden Elements gleich der Breite einer Leiterbahn in der obersten Verdrahtungsebene ist.

7. Kontaktanschluß nach einem der vorhergehenden Ansprüche,
**dadurch gekennzeichnet, daß**
die erste Isolation ein Polymer oder ein Siliziumdioxid, das eine relative Dielektrizitätskonstante von kleiner als 3 aufweist, ist.
